# EUROPÄISCHE PATENTSCHRIFT

(11) **EP 4 084 088 B1**
(45) Veröffentlichungstag und Bekanntmachung des Hinweises auf die Patenterteilung: **13.11.2024**
(21) Anmeldenummer: 22169959.8
(22) Anmeldetag: 26.04.2022
(51) Int. Cl.: H01L 31/042, H02S 40/22, H02S 40/42

(54) **REFLEKTOREINHEIT FÜR EIN BIFAZIALES SOLARMODUL UND SOLARMODULSYSTEM DAMIT**
REFLECTOR UNIT FOR A BIFACIAL SOLAR MODULE AND SOLAR MODULE SYSTEM COMPRISING THE SAME
UNITÉ DE RÉFLECTEUR POUR UN MODULE SOLAIRE BIFACIAL ET SYSTÈME DE MODULE SOLAIRE ASSOCIÉ

(30) Priorität: 27.04.2021 DE 102021110752
(43) Veröffentlichungstag der Anmeldung: 02.11.2022
(73) Patentinhaber: HS Holding GmbH, 26904 Börger (DE)
(72) Erfinder: Schmees, Hermann, 26904 Börger (DE)
(74) Vertreter: Jabbusch, Matthias

(56) Entgegenhaltungen:
- DE-A1- 102015 120 521
- FR-A1- 3 042 353
- JP-A- 2001 127 331
- US-A1- 2008 128 015
- US-A1- 2016 359 447
- US-A1- 2017 155 360

## Beschreibung

Die Erfindung betrifft eine Reflektoreinheit für ein bifaziales Solarmodul nach dem Oberbegriff des Patentanspruchs 1. Die Erfindung betrifft weiter ein Solarmodulsystem mit der erfindungsgemäßen Reflektoreinheit. Ein derartiges bifaziales Solarmodul weist einen Modulrahmen und eine Vielzahl von im Modulrahmen angeordneten bifazialen Solarzellen auf. Die bifazialen Solarzellen können auch aus Licht, das von der Rückseite auf die bifazialen Solarzellen fällt, elektrische Energie zu erzeugen.

Ein bifaziales Solarmodul ist also dazu in der Lage, das Licht, das an den Vorderseiten der bifazialen Solarzellen vorbei zunächst ungenutzt zwischen den einzelnen Solarzellen hindurch fällt, zu nutzen, wenn dieses Licht auf die Rückseiten der bifazialen Solarzellen reflektiert wird. Wenn das Solarmodul über einem Dach montiert wird, reflektiert also das Dach Licht auf die Rückseite des Solarmoduls zurück. Bei einer hohen Albedo des Daches wird dabei besonders viel Licht für die solare Energiegewinnung nutzbar gemacht.

Aus US 2016/359447 A1, aus JP 2001127331 A, aus FR 3 042 353 A1 und aus US 2008/128015 A1 ist jeweils bekannt, hinter den Solarzellen eines Solarmoduls eine Reflektoreinheit in Form eines Reflektors vorzusehen. Licht, das von der Vorderseite des Solarmoduls kommend zwischen den Solarzellen durch das Solarmodul hindurch auf den Reflektor fällt, wird somit zurück auf die Rückseite des Solarmoduls reflektiert. Der Reflektor ist bei den bekannten Reflektoreinheiten entweder in den Rahmen des Solarmoduls integriert oder an den Rahmen des Solarmoduls angesetzt.

Aufgrund des Reflektors kann insbesondere bei den in JP 2001127331 A und FR 3 042 353 A1 offenbarten Anordnungen des Reflektors die Hinterlüftung des Solarmoduls beeinträchtigt sein. Das Solarmodul kann sich daher im Betrieb ungünstig erwärmen, was dazu führt, dass die Leistungsfähigkeit des Solarmoduls sinkt. US 2016/359447 A1 beschreibt ein Ausführungsbeispiel mit Lüftungsschlitzen im Modulrahmen des Solarmoduls, die für eine Belüftung der im Solarmodul verbauten Solarzellen sorgen. Bei US 2008/128015 A1 sorgt ein perforierter Reflektor für die Kühlung des Solarmoduls.

Der Erfindung liegt die Aufgabe zugrunde, eine Reflektoreinheit für ein bifaziales Solarmodul und ein Solarmodulsystem mit einem bifazialen Solarmodul und mit der Reflektoreinheit bereitzustellen, wobei mit niedrigem Aufwand und mit niedrigen Kosten für das Solarmodulsystem eine hohe Energieausbeute des Solarmoduls ermöglicht wird.

Die Erfindung löst diese Aufgabe mit einer Reflektoreinheit nach dem Patentanspruch 1 und mit einem Solarmodulsystem nach dem Patentanspruch 13. Vorteilhafte Ausführungsformen der Erfindung sind in den Unteransprüchen angegeben.

Bei einer Reflektoreinheit für ein bifaziales Solarmodul, welches einen Modulrahmen und eine Vielzahl von im Modulrahmen angeordneten bifazialen Solarzellen aufweist, mit einem lichtreflektierenden Reflektor zum Reflektieren von Licht, das von der Vorderseite des Solarmoduls kommend zwischen den Solarzellen durch das Solarmodul hindurch auf den Reflektor fällt, zurück auf die Rückseite der Solarzellen, ist erfindungswesentlich vorgesehen, dass die Reflektoreinheit einen den Reflektor tragenden und am Modulrahmen anbaubaren Reflektorrahmen mit Profilelementen zum nachträglichen Anbauen der Reflektoreinheit rückseitig an das Solarmodul mit einem definierten Abstand des Reflektors relativ zum Solarmodul aufweist, dass die Profilelemente des Reflektorrahmens zumindest an zwei einander gegenüberliegenden Seiten der Reflektoreinheit angeordnet sind und dass der Reflektorrahmen Lüftungsschlitze in wenigstens zwei Profilelementen des Reflektorrahmens aufweist.

Viele handelsübliche bifaziale Solarmodule, die einen Modulrahmen aufweisen, können auf diese Weise nachträglich mit einem Reflektor ausgestattet werden. Hierfür kann eine erfindungsgemäße Reflektoreinheit mit einem geeigneten Reflektorrahmen ausgewählt werden oder der Reflektorrahmen an die Abmessungen des Modulrahmens angepasst werden und kann anschließend der Reflektorrahmen am Modulrahmen befestigt werden. Der vom Reflektorrahmen getragene Reflektor nimmt dann automatisch einen, insbesondere durch die Konstruktion des Reflektorrahmens, definierten Abstand zum Solarmodul ein. Dieser Abstand ist insbesondere der Abstand zum Reflektorrahmen. Der Abstand zu den Solarzellen ist demgegenüber in der Regel noch einmal vergrößert. Durch den Abstand des Reflektors zum Solarmodul und Dank der Lüftungsschlitze in den Profilelementen werden die Solarzellen vorteilhaft hinterlüftet, was einer Erwärmung der Solarzellen und damit einer temperaturbedingten Schwächung des Wirkungsgrades der Solarzellen entgegenwirkt.

Der Reflektorrahmen weist vorzugsweise vordere Abschnitte mit in einer vorderen Kontaktebene angeordneten vorderen Kontaktfläche zur Kontaktierung mit dem Modulrahmen auf. Der Reflektor weist eine den Solarzellen zugewandte Reflektoroberfläche auf. Diese Reflektoroberfläche liegt wahlweise in einer Ebene oder ist strukturiert. Bevorzugt ist vorgesehen, dass diese Reflektoroberfläche in einem Abstand von mehr als 1 cm, vorzugsweise mehr als 3 cm, und von weniger als 15 cm, vorzugsweise weniger als 10 cm, zur vorderen Kontaktebene angeordnet ist. Bei Ausführungsformen, bei denen die Reflektoroberfläche strukturiert ist, ist die Reflektoroberfläche in einem Abstandsbereich relativ zur vorderen Kontaktebene angeordnet. Der Abstand bemisst sich jeweils senkrecht zur vorderen Kontaktebene.

Bei einer Ausführungsform der erfindungsgemäßen Reflektoreinheit ist vorgesehen, dass der Reflektorrahmen unterbrochen ist. Bei einer Ausführungsform der Erfindung weist der Reflektorrahmen genau zwei Profilelemente auf, die an einander gegenüberliegenden Seiten der Reflektoreinheit angeordnet sind. Besonders bevorzugt sind an den einander gegenüberliegenden Seiten mit Abstand zueinander jeweils mehrere Profilelemente angeordnet. Weiter ist bevorzugt vorgesehen, dass die senkrecht zwischen diesen Profilelementen angeordneten Seiten der Reflektoreinheit ganz oder teilweise frei von Profilelementen sind. Luft kann somit an einer Seite des Reflektorrahmens zwischen die Solarzellen und den Reflektor einströmen, Wärme von den Solarzellen aufnehmen und zumindest auf der gegenüberliegenden Seite des Reflektorrahmens wieder ausströmen. Dadurch wird die Kühlung der Solarzellen verbessert. Alternativ sind an allen Seiten der Reflektoreinheit jeweils mehrere Profilelemente mit Abstand zueinander angeordnet.

Bei einer alternativen Ausführungsform der erfindungsgemäßen Reflektoreinheit ist vorgesehen, dass der Reflektorrahmen umfänglich geschlossen ist, wobei an jeder Seite der Reflektoreinheit wenigstens ein Profilelement des Reflektorrahmens angeordnet ist.

Bei einer Ausführungsform der Erfindung weist der Reflektorrahmen die Lüftungsschlitze in allen Profilelementen auf. Auch Dank der Lüftungsschlitze kann eine Hinterlüftung der Solarzellen erreicht werden.

Die Profilelemente weisen vorzugsweise ein U-Profil auf, bestehen also insbesondere aus drei rechtwinklig aneinander angrenzenden Abschnitten. Die offene Seite der Profilelemente weist dabei, insbesondere bezogen auf den gesamten Reflektorrahmen, nach innen. Das U-Profil sorgt für Stabilität und erleichtert die Befestigung des Reflektorrahmens sowohl am Reflektor bei der Herstellung der Reflektoreinheit als auch bei der nachträglichen Montage der Reflektoreinheit an einem handelsüblichen Solarmodul.

Besonders bevorzugt ist der Reflektor selbsttragend ausgebildet und ausschließlich in seinen Randbereichen mit dem Reflektorrahmen verbunden.

Dies macht etwaige Tragelemente oder Stützelemente zwischen dem Reflektor und den Solarzellen entbehrlich und ermöglicht somit eine einfache und kostengünstige Konstruktion sowie eine vorteilhafte Reflektion von Licht auf die Solarzellen.

Der selbsttragend ausgebildete Reflektor weist vorzugsweise mehrere parallel zueinander verlaufende Sicken, die sich zwischen den Randbereichen erstrecken, zur Stabilisierung des Reflektors auf. Die Sicken weisen dabei insbesondere die Form von streifenförmigen und aus der zum Solarmodul weisenden Oberfläche des Reflektors konvex vorstehenden Abschnitte auf. Die Sicken stehen damit in Richtung der Solarzellen gegenüber der umgebenden Oberfläche des Reflektors vor. Alternativ sind die Sicken jedoch zur Rückseite der Reflektoreinheit vorstehend ausgebildet. Die Sicken erstrecken sich insbesondere zwischen den Randbereichen des Reflektors, an denen der Reflektor mit dem Reflektorrahmen verbunden ist.

Der Reflektorrahmen weist vorzugsweise hintere Abschnitte mit in einer hinteren Kontaktebene angeordneten hinteren Kontaktflächen zur Kontaktierung mit der parallel zu dieser Kontaktebene ausgerichteten und den Solarzellen zugewandten Oberfläche von Randbereichen des Reflektors auf. Die hinteren Kontaktflächen sind insbesondere Abschnitte der U-Profile.

Bei einer vorteilhaften Ausführungsform der Reflektoreinheit ist die den Solarzellen zugewandte Oberfläche des Reflektors diffus reflektierend ausgebildet. Dadurch wird das reflektierte Licht besonders gleichmäßig verteilt auf die Solarzellen zurückgestreut. Insbesondere weist der Reflektor eine Beschichtung mit einer Albedo von mindestens 0,80, vorzugsweise mindestens 0,85, auf.

Der Reflektor ist vorzugsweise mittels Schraubverbindungen am Reflektorrahmen befestigt und vom Reflektorrahmen gehalten. Hierfür ist bevorzugt vorgesehen, dass die Reflektoreinheit mehrere hintere Schraubverbindungen aufweist, mittels denen der Reflektor mit dem Reflektorrahmen, insbesondere hinteren Abschnitten des Reflektorrahmens, verschraubt ist. Alternativ ist der Reflektorrahmen beispielsweise mit dem Reflektor mittels einer Klebeverbindung verbunden.

Das erfindungsgemäße Solarmodulsystem ist mit einem bifazialen Solarmodul, welches einen Modulrahmen und eine Vielzahl von im Modulrahmen angeordneten bifazialen Solarzellen aufweist, und mit einer am Solarmodul befestigten erfindungsgemäßen Reflektoreinheit ausgestattet. Das Solarmodul kann hierbei von herkömmlicher Bauart sein. Die Reflektoreinheit ist insbesondere in ihren Abmessungen an das Solarmodul angepasst.

Bevorzugt weist das Solarmodulsystem mehrere vordere Schraubverbindungen auf, mittels denen der Reflektorrahmen mit dem Modulrahmen verschraubt ist, insbesondere vordere Abschnitte des Reflektorrahmens mit dem Modulrahmen verschraubt sind. Alternativ oder zusätzlich weist das Solarmodulsystem mehrere vordere Klebeverbindungen auf, mittels denen der Reflektorrahmen mit dem Modulrahmen verklebt ist, insbesondere vordere Abschnitte des Reflektorrahmens mit dem Modulrahmen verklebt sind.

Das Solarmodulsystem mit dem selbsttragend ausgebildeten und ausschließlich in seinen Randbereichen mit dem Reflektorrahmen verbundenen Reflektor, wobei der Reflektor mehrere parallel zueinander verlaufende Sicken, die sich zwischen den Randbereichen erstrecken, zur Stabilisierung des Reflektors aufweist, ist vorzugsweise dadurch weitergebildet, dass jede Sicke vollständig unter jeweils genau einer Reihe von Solarzellen und deren Zwischenräumen angeordnet ist. Dadurch wird eine vorteilhafte Streuung des Lichts auf die Rückseite der Solarzellen erreicht.

Weitere Ausführungsformen ergeben sich aus den Ansprüchen, aus den Zeichnungen und aus der nachfolgenden Beschreibung eines in den Zeichnungen dargestellten besonders bevorzugten Ausführungsbeispiels der Erfindung. In den Zeichnungen zeigen:
- Fig. 1:: einen Ausschnitt eines Solarmodulsystems mit einem Solarmodul und einer Reflektoreinheit gemäß einem Ausführungsbeispiel der Erfindung in einer ersten Seitenschnittdarstellung; und
- Fig. 2:: einen Ausschnitt des Solarmodulsystems des Ausführungsbeispiels von Fig. 1 in einer gegenüber der ersten Seitenschnittdarstellung von Fig. 1 um 90° gedrehten zweiten Seitenschnittdarstellung entlang der Linie A aus Fig. 1.

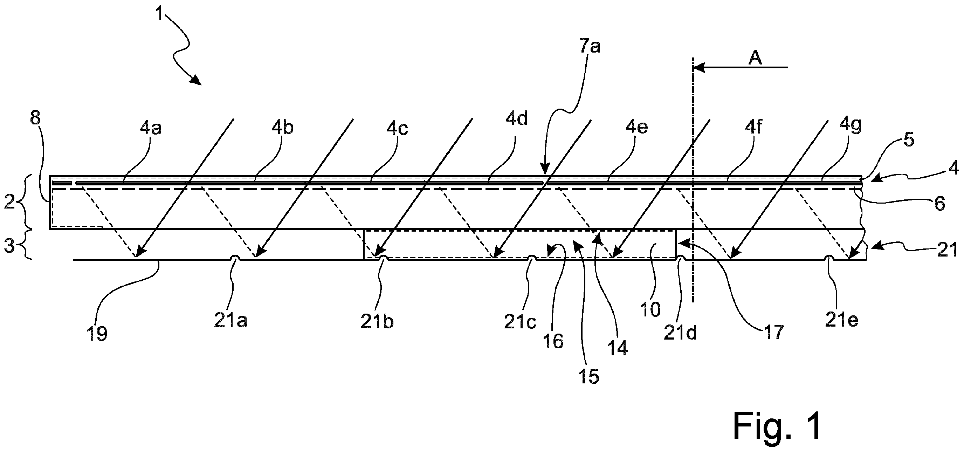

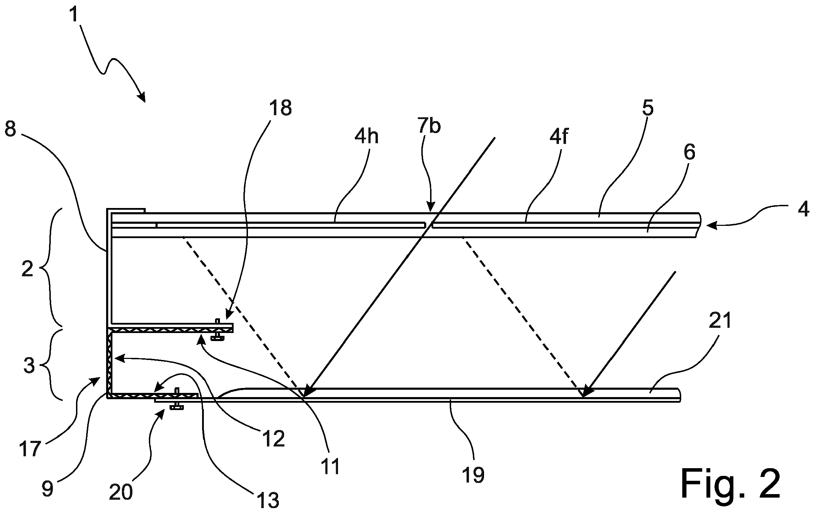

In den Figuren 1 und 2 ist ein Solarmodulsystem 1, bestehend aus einem bifazialen Solarmodul 2 und einer Reflektoreinheit 3 dargestellt. Gleiche Bezugszeichen bezeichnen in beiden Figuren die gleichen Teile.

Das Solarmodul 2 ist von herkömmlicher Bauart und weist eine Vielzahl von bifazialen Solarzellen 4 und einen Modulrahmen 5 auf. Die einzelnen in Fig. 1 geschnitten dargestellten Solarzellen 4 sind mit dem Bezugszeichen 4 a bis 4 g bezeichnet. Die neben der Solarzelle 4 f in Fig. 2 ebenfalls geschnitten dargestellte Solarzelle 4 ist mit dem Bezugszeichen 4 h bezeichnet. Die Solarzellen 4 sind nebeneinander, jedoch durch Spalte 7 a und 7 b beabstandet voneinander, zwischen einer vorderen Glasscheibe 5 und einer hinteren Glasscheibe 6 angeordnet. In Fig. 1 ist beispielhaft der Spalt 7 a zwischen den Solarzellen 4 d und 4 e bezeichnet. In Fig. 2 ist beispielhaft der senkrecht zum Spalt 7 a verlaufende Spalt 7 b zwischen den Solarzellen 4 h und 4 f bezeichnet. Das Solarmodul 2 weist einen Modulrahmen 8 auf, in welchem die Glasscheiben 5 und 6 mit den dazwischen angeordneten Solarzellen 4 gehalten werden. Der Modulrahmen 8 weist ein U-Profil mit einem vorderen Abschnitt, einem seitlichen Abschnitt und einem hinteren Abschnitt auf. Der seitliche Abschnitt fasst die Glasscheiben 5 und 6 an ihren schmalen Seiten ein. Der vordere Abschnitt liegt vorderseitig an der vorderen Glasscheibe 5 an. Der hintere Abschnitt ist parallel zum vorderen Abschnitt und beabstandet von der hinteren Glasscheibe 6 angeordnet.

Die Reflektoreinheit 3 weist an einander gegenüberliegenden Seiten ein erstes Profilelement 9 und ein zweites Profilelement 10 auf. Die Profilelemente 9 und 10 sind aus Metall, insbesondere Aluminium, gebildet und weisen jeweils ein U-Profil auf. Die Profilelemente 9 und 10 sind gleichartig ausgebildet. Das Profilelement 9 weist einen vorderen Abschnitt 11, einen rechtwinklig an den vorderen Abschnitt 11 angrenzenden seitlichen Abschnitt 12 und einen rechtwinklig an den seitlichen Abschnitt 12 angrenzenden und parallel zum vorderen Abschnitt 11 ausgerichteten hinteren Abschnitt 13 auf. Das Profilelement 10 weist entsprechend einen vorderen Abschnitt 14, einen seitlichen Abschnitt 15 und einen hinteren Abschnitt 16 auf. Die Profilelemente 9 und 10 bilden zusammen einen Reflektorrahmen 17. Der Reflektorrahmen 17 ist zwischen den Profilelementen 9 und 10 unterbrochen, also jeweils beidseitig seitlich neben den Profilelementen 9 und 10 und an den senkrecht zu den Profilelementen 9 und 10 angeordneten Seiten der Reflektoreinheit 3.

In Abweichung vom dargestellten Ausführungsbeispiel kann der Reflektorrahmen 17 jedoch auch weitere Profilelemente an den mit den Profilelementen 9 und 10 ausgerüsteten Seiten oder an den übrigen Seiten der Reflektoreinheit 3 aufweisen. Auch eine Ausbildung des Reflektorrahmens 17 als ohne Unterbrechung umlaufender Rahmen ist möglich, wobei der Reflektorrahmen 17 hierbei vorzugsweise in den seitlichen Abschnitten 12 Aussparungen für eine Hinterlüftung der Solarzellen 4 hinter der hinteren Glasscheibe 6 aufweist.

Die vorderen Abschnitte 11 und 14 der Profilelemente 9 und 10 sind mittels vorderen Schraubverbindungen 18 mit dem Modulrahmen 8 verbunden. Alternativ oder zusätzlich erfolgt die Verbindung zwischen den vorderen Abschnitten 11 und 14 der Profilelemente 9 und 10 mit dem Modulrahmen 8 mittels Klebeverbindungen. Die Reflektoreinheit 3 weist einen vom Reflektorrahmen 17 getragenen Reflektor 19 auf, der mittels hinteren Schraubverbindungen 20 am Reflektorrahmen 17 befestigt ist. Hierfür weist der Reflektor 19 in seinem Randbereich Durchgangslöcher für Schrauben auf, mittels welcher die hinteren Schraubverbindungen 20 hergestellt sind. Alternativ oder zusätzlich besteht eine Klebeverbindung zwischen dem Reflektorrahmen 17 und dem Reflektor 19.

Der Reflektor 19 weist mehrere parallel zueinander verlaufende Sicken 21 auf. Die einzelnen Sicken 21 sind zur Unterscheidung in Fig. 1 mit den Bezugszeichen 21 a, 21 b, 21 c, 21 d und 21 e bezeichnet. Jede Sicke 21 ist im dargestellten Ausführungsbeispiel in Richtung des Solarmoduls 2 konvex, insbesondere bogenförmig, vorstehend ausgebildet. Der Reflektor 19 ist vorzugsweise aus Metall ausgebildet und derart beschichtet, dass ein sehr hoher Anteil des auf die Oberfläche des Reflektors 19 auftreffenden Lichts reflektiert wird, insbesondere diffus gestreut wird.

Dank der nachträglich am Solarmodul 2 montierbaren Reflektoreinheit 3 ist auf einfache Weise das Solarmodulsystem 1 hergestellt. Das Solarmodulsystem 1 kann beispielsweise auf Dächern montiert werden und dank der Durchlüftung zwischen dem Reflektor 19 und dem Solarmodul 2 auch bei hohen Temperaturen eine hohe Energieausbeute liefern. Dabei wird Licht, welches durch die Spalte 7 a und 7 b auf den Reflektor 19 fällt, auf die Rückseite der Solarzellen 4 reflektiert. Hierdurch wird insgesamt der Energieertrag durch die Solarzellen 4 erhöht.

## Patentansprüche

1. Reflektoreinheit für ein bifaziales Solarmodul (2), welches einen Modulrahmen (8) und eine Vielzahl von im Modulrahmen (8) angeordneten bifazialen Solarzellen (4) aufweist, mit einem lichtreflektierenden Reflektor (19) zum Reflektieren von Licht, das von der Vorderseite des Solarmoduls (2) kommend zwischen den Solarzellen (4) durch das Solarmodul (2) hindurch auf den Reflektor (19) fällt, zurück auf die Rückseite der Solarzellen (4),
**dadurch gekennzeichnet,**
**dass** die Reflektoreinheit (3) einen den Reflektor (19) tragenden und am Modulrahmen (8) anbaubaren Reflektorrahmen (17) mit Profilelementen (9, 10) zum nachträglichen Anbauen der Reflektoreinheit (3) rückseitig an das Solarmodul (2) mit einem definierten Abstand des Reflektors (19) relativ zum Solarmodul (2) aufweist,
**dass** die Profilelemente (9, 10) des Reflektorrahmens (17) zumindest an zwei einander gegenüberliegenden Seiten der Reflektoreinheit (3) angeordnet sind und dass der Reflektorrahmen (17) Lüftungsschlitze in wenigstens zwei Profilelementen (9, 10) des Reflektorrahmens (17) aufweist.

2. Reflektoreinheit nach Anspruch 1, **dadurch gekennzeichnet, dass** der Reflektorrahmen (17) vordere Abschnitte (11, 14) mit in einer vorderen Kontaktebene angeordneten vorderen Kontaktflächen zur Kontaktierung mit dem Modulrahmen (8) aufweist und dass der Reflektor (19) eine den Solarzellen (4) zugewandte Reflektoroberfläche aufweist, die in einem Abstand von mehr als 1 cm, vorzugsweise mehr als 3 cm, und von weniger als 15 cm, vorzugsweise weniger als 10 cm, zur vorderen Kontaktebene angeordnet ist.

3. Reflektoreinheit nach einem der Ansprüche 1 und 2, **dadurch gekennzeichnet, dass** der Reflektorrahmen (17) unterbrochen ist, wobei die Seiten der Reflektoreinheit (3), die senkrecht zwischen wenigstens zwei oder genau zwei an einander gegenüberliegenden Seiten der Reflektoreinheit (3) angeordneten Profilelementen (9, 10) des Reflektorrahmens (17) angeordnet sind, ganz oder teilweise frei von Profilelementen (9, 10) sind.

4. Reflektoreinheit nach einem der Ansprüche 1 und 2, **dadurch gekennzeichnet, dass** der Reflektorrahmen (17) umfänglich geschlossen ist, wobei an jeder Seite der Reflektoreinheit (3) wenigstens ein Profilelement (9, 10) des Reflektorrahmens (17) angeordnet ist.

5. Reflektoreinheit nach einem der vorhergehenden Ansprüche, **dadurch gekennzeichnet, dass** der Reflektorrahmen (17) die Lüftungsschlitze in wenigstens zwei einander gegenüberliegenden Profilelementen (9, 10) des Reflektorrahmens aufweist.

6. Reflektoreinheit nach einem der vorhergehenden Ansprüche, **dadurch gekennzeichnet, dass** die Profilelemente (9, 10) ein U-Profil aufweisen.

7. Reflektoreinheit nach einem der vorhergehenden Ansprüche, **dadurch gekennzeichnet, dass** der Reflektor (19) selbsttragend ausgebildet und ausschließlich in seinen Randbereichen mit dem Reflektorrahmen (17) verbunden ist.

8. Reflektoreinheit nach Anspruch 7, **dadurch gekennzeichnet, dass** der Reflektor (19) mehrere parallel zueinander verlaufende Sicken (21), die sich zwischen den Randbereichen erstrecken, zur Stabilisierung des Reflektors (19) aufweist.

9. Reflektoreinheit nach Anspruch 8, **dadurch gekennzeichnet, dass** die Sicken (21) die Form von streifenförmigen und aus der zum Solarmodul (2) weisenden Oberfläche des Reflektors (19) konvex vorstehenden Abschnitten aufweisen.

10. Reflektoreinheit nach einem der vorhergehenden Ansprüche, **dadurch gekennzeichnet, dass** der Reflektorrahmen (17) hintere Abschnitte (13, 16) mit in einer hinteren Kontaktebene angeordneten hinteren Kontaktflächen zur Kontaktierung mit der parallel zu dieser Kontaktebene ausgerichteten und den Solarzellen (4) zugewandten Oberfläche von Randbereichen des Reflektors (19) aufweist.

11. Reflektoreinheit nach einem der vorhergehenden Ansprüche, **dadurch gekennzeichnet, dass** die den Solarzellen (4) zugewandte Oberfläche des Reflektors (19) diffus reflektierend ausgebildet ist, insbesondere der Reflektor (19) eine Beschichtung mit einer Albedo von mindestens 0,80, vorzugsweise mindestens 0,85, aufweist.

12. Reflektoreinheit nach einem der vorhergehenden Ansprüche, **dadurch gekennzeichnet, dass** die Reflektoreinheit (3) mehrere hintere Schraubverbindungen (20) aufweist, mittels denen der Reflektor (19) mit dem Reflektorrahmen (17), insbesondere hinteren Abschnitten (13, 16) des Reflektorrahmens (17), verschraubt ist.

13. Solarmodulsystem mit einem bifazialen Solarmodul (2), welches einen Modulrahmen (8) und eine Vielzahl von im Modulrahmen (8) angeordneten bifazialen Solarzellen (4) aufweist, und mit einer am Solarmodul (2) befestigten Reflektoreinheit (3) nach einem der vorhergehenden Ansprüche.

14. Solarmodulsystem nach Anspruch 13, **dadurch gekennzeichnet, dass** das Solarmodulsystem (1) mehrere vordere Schraubverbindungen (18) aufweist, mittels denen der Reflektorrahmen (17) mit dem Modulrahmen (8) verschraubt ist, insbesondere vordere Abschnitte (11, 14) des Reflektorrahmens (17) mit dem Modulrahmen (8) verschraubt sind, oder mehrere vordere Klebeverbindungen aufweist, mittels denen der Reflektorrahmen (17) mit dem Modulrahmen (8) verklebt ist, insbesondere vordere Abschnitte (11, 14) des Reflektorrahmens (17) mit dem Modulrahmen (8) verklebt sind.

15. Solarmodulsystem nach einem der Ansprüche 13 und 14, wobei die Reflektoreinheit (3) nach Anspruch 8 ausgebildet ist, **dadurch gekennzeichnet, dass** jede Sicke (21) vollständig unter jeweils genau einer Reihe von Solarzellen (4) und deren Zwischenräumen angeordnet ist.

## Claims

1. A reflector unit for a bifacial solar module (2) which comprises a module frame (8) and a plurality of bifacial solar cells (4) arranged in the module frame (8), with a light-reflecting reflector (19) for reflecting light arriving from the front side of the solar module (2) that falls between the solar cells (4) through the solar module (2) onto the reflector (19) back onto the rear side of the solar cells (4),
**characterized in that**
the reflector unit (3) comprises a reflector frame (17), which supports the reflector (19) and which is attachable to the module frame (8), with profile elements (9, 10) for a retrofitting attachment of the reflector unit (3) to the rear side of the solar module (2) with a defined clearance of the reflector (19) relative to the solar module (2),
wherein the profile elements (9, 10) of the reflector frame (17) are arranged at least on two opposite sides of the reflector unit (3), and wherein the reflector frame (17) comprises ventilation slits in at least two profile elements (9, 10) of the reflector frame (17).

2. The reflector unit according to claim 1, **characterized in that** the reflector frame (17) comprises front sections (11, 14) with front contact surfaces arranged in a front contact plane for contacting the module frame (8), wherein the reflector (19) comprises a reflector surface facing the solar cells (4) which is arranged at a distance of more than 1 cm, preferably more than 3 cm, and less than 15 cm, preferably less than 10 cm, from the front contact plane.

3. The reflector unit according to one of claims 1 and 2, **characterized in that** the reflector frame (17) is interrupted, wherein the sides of the reflector unit (3) that are perpendicular between at least two or exactly two profile elements (9, 10) of the reflector frame (17) that are arranged on opposite sides of the reflector unit (3) are entirely or partially free of profile elements (9, 10).

4. The reflector unit according to one of claims 1 and 2, **characterized in that** the reflector frame (17) is closed around its perimeter, wherein at least one profile element (9, 10) of the reflector frame (17) is arranged on each side of the reflector unit (3).

5. The reflector unit according to one of the preceding claims, **characterized in that** the reflector frame (17) comprises the ventilation slits in at least two profile elements (9, 10) of the reflector frame that lie opposite each other.

6. The reflector unit according to one of the preceding claims, **characterized in that** the profile elements (9, 10) comprise a U-profile.

7. The reflector unit according to one of the preceding claims, **characterized in that** the reflector (19) is designed to be self-supporting and is connected to the reflector frame (17) only in its edge areas.

8. The reflector unit according to claim 7, **characterized in that** the reflector (19) comprises a plurality of corrugations (21), which run parallel to one another and which extend between the edge areas, for stabilizing the reflector (19).

9. The reflector unit according to claim 8, **characterized in that** the corrugations (21) have the form of strip-shaped sections that project in a convex manner from the surface of the reflector (19) that faces the solar module (2).

10. The reflector unit according to one of the preceding claims, **characterized in that** the reflector frame (17) comprises rear sections (13, 16) with rear contact surfaces arranged in a rear contact plane for contacting the surface, which faces the solar cells (4) and is oriented parallel to said contact plane, of edge areas of the reflector (19).

11. The reflector unit according to one of the preceding claims, **characterized in that** the surface of the reflector (19) that faces the solar cells (4) is designed to be diffusely reflective, the reflector (19) in particular comprising a coating with an albedo of at least 0.80, preferably at least 0.85.

12. The reflector unit according to one of the preceding claims, **characterized in that** the reflector unit (3) comprises a plurality of rear screw connections (20) by means of which the reflector (19) is screwed to the reflector frame (17), in particular to rear sections (13, 16) of the reflector frame (17).

13. A solar module system with a bifacial solar module (2) which comprises a module frame (8) and a plurality of bifacial solar cells (4) arranged in the module frame (8), and with a reflector unit (3) according to one of the preceding claims fixed to the solar module (2).

14. The solar module system according to claim 13, **characterized in that** the solar module system (1) comprises a plurality of front screw connections (18) by means of which the reflector frame (17) is screwed to the module frame (8), in particular front sections (11, 14) of the reflector frame (17) are screwed to the module frame (8), or comprises a plurality of front adhesive connections by means of which the reflector frame (17) is glued to the module frame (8), in particular front sections (11, 14) of the reflector frame (17) are glued to the module frame (8) .

15. The solar module system according to one of claims 13 and 14, wherein the reflector unit (3) is designed according to claim 8, **characterized in that** each corrugation (21) is arranged entirely under respectively exactly one row of solar cells (4) and their interspaces.

## Revendications

1. Unité réflectrice pour un module solaire bifacial (2), qui présente un cadre de module (8) et une pluralité de cellules solaires bifaciales (4) disposées dans le cadre du module (8), comportant un réflecteur réfléchissant la lumière (19) pour réfléchir la lumière provenant de l'avant du module solaire (2) entre les cellules solaires (4) à travers le module solaire (2) en retombant sur le réflecteur (19) à l'arrière des cellules solaires (4),
**caractérisé en ce que**
l'unité réflectrice (3) présente un cadre réflecteur (17) qui porte le réflecteur (19) et qui peut être fixé au cadre de module (8) avec des éléments profilés (9, 10) pour fixer ultérieurement l'unité réflectrice (3) à l'arrière du module solaire (2) à une distance définie du réflecteur (19) par rapport au module solaire (2),
que les éléments profilés (9, 10) du cadre réflecteur (17) sont disposés au moins sur deux côtés opposés de l'unité réflectrice (3) et que le cadre réflecteur (17) présente des fentes d'aération dans au moins deux éléments profilés (9, 10) du cadre réflecteur (17).

2. Unité réflectrice selon la revendication 1, **caractérisée en ce que** le cadre réflecteur (17) présente des sections avant (11, 14) avec des surfaces de contact avant disposées dans un plan de contact avant pour entrer en contact avec le cadre de module (8) et que le réflecteur (19) présente une surface réflectrice tournées vers les cellules solaires (4), qui est disposée à distance de plus de 1 cm, de préférence de plus de 3 cm, et de moins de 15 cm, de préférence de moins de 10 cm, par rapport au plan de contact avant.

3. Unité réflectrice selon une des revendications 1 et 2, **caractérisé en ce que** le cadre réflecteur (17) est interrompu, dans lequel les côtés de l'unité réflectrice (3), qui sont disposées verticalement entre au moins deux ou exactement deux éléments profilés (9, 10) du cadre réflecteur (17) disposés sur les côtés opposés de l'unité réflectrice (3), sont totalement ou partiellement exempts d'éléments de profil (9, 10).

4. Unité réflectrice selon une des revendications 1 et 2, **caractérisée en ce que** le cadre réflecteur (17) est fermé circonférentiellement, dans lequel au moins un élément profilé (9, 10) du cadre réflecteur (17) est disposé de chaque côté de l'unité réflectrice (3).

5. Unité réflectrice selon une des revendications précédentes, **caractérisée en ce que** le cadre réflecteur (17) présente des fentes d'aération dans au moins deux éléments profilés opposés (9, 10) du cadre réflecteur.

6. Unité réflectrice selon une des revendications précédentes, **caractérisé en ce que** les éléments profilés (9, 10) présentent un profil en U.

7. Unité réflectrice selon une des revendications précédentes, **caractérisée en ce que** le réflecteur (19) est autoporteur et est relié au cadre réflecteur (17) exclusivement dans ses zones de bord.

8. Unité réflectrice selon la revendication 7, **caractérisé en ce que** le réflecteur (19) présente plusieurs moulures parallèles (21), qui s'étendent entre les régions de bord, pour stabiliser le réflecteur (19).

9. Unité réflectrice selon la revendication 8, **caractérisé en ce que** les moulures (21) ont la forme de sections en forme de bande qui dépassent de manière convexe de la surface du réflecteur (19) tournée vers le module solaire (2).

10. Unité réflectrice selon une des revendications précédentes, **caractérisé en ce que** le cadre réflecteur (17) présente des sections arrière (13, 16) avec des surfaces de contact arrière disposées dans un plan de contact arrière pour contacter la surface des régions de bord du réflecteur (19) qui est alignée parallèlement à ce plan de contact et fait face aux cellules solaires (4).

11. Unité réflectrice selon une des revendications précédentes, **caractérisée en ce que** la surface tournée vers les cellules solaires (4) du réflecteur (19) est conçu pour être à réflexion diffuse, notamment le réflecteur (19) présente un revêtement ayant un albédo d'au moins 0,80, de préférence d'au moins 0,85.

12. Unité réflectrice selon une des revendications précédentes, **caractérisé en ce que** l'unité réflectrice (3) présente une pluralité de raccords vissés arrière (20), au moyen desquels le réflecteur (19) est vissé au cadre réflecteur (17), en particulier des sections arrière (13, 16) du cadre réflecteur (17).

13. Système de module solaire comportant un module solaire bifacial (2), qui présente un cadre de module (8) et une pluralité de cellules solaires bifaciales (4) disposées dans le cadre de module (8) et comportant une unité réflectrice (3) fixée au module solaire (2) selon une des revendications précédentes.

14. Système de module solaire selon la revendication 13, **caractérisé en ce que** le système de module solaire (1) présente une pluralité de raccords vissés avant (18), au moyen desquels le cadre réflecteur (17) est vissé au cadre du module (8), en particulier les parties avant (11, 14) du cadre réflecteur (17) sont vissées au cadre de module (8) ou présentent plusieurs liaisons adhésives avant, au moyen desquelles le cadre réflecteur (17) est collé au cadre de module (8), en particulier les sections avant (11, 14) du cadre réflecteur (17) sont collées au cadre de module (8).

15. Système de module solaire selon une des revendications 13 et 14, dans lequel l'unité réflectrice (3) est conçue selon la revendication 8, **caractérisé en ce que** chaque moulure (21) est disposée entièrement sous exactement une rangée de cellules solaires (4) et leurs espaces intermédiaires.
